# EUROPEAN PATENT APPLICATION

(11) **EP 0 858 105 A2**
(43) Date of publication of application: **12.08.1998**
(21) Application number: 98300091.0
(22) Date of filing: 06.01.1998
(51) Int. Cl.: H01L 21/8242

(54) **Method of forming a stacked capacitor electrode for a DRAM**

(30) Priority: 06.01.1997 US 34533 P
(71) Applicant: TEXAS INSTRUMENTS INC., Dallas, Texas 75243 (US)
(72) Inventor: Crenshaw, Darius L., Allen, Texas 75002 (US); Shu, Jing-Shing, Richardson, Texas 75082 (US)
(74) Representative: Blanco White, Henry Nicholas

(57) **Abstract**

A method for forming a bottom electrode (68) of a stacked capacitor of a dynamic random access memory cell is provided. The method includes the steps of forming a storage node contact area (62) within an insulator layer that may be provided as a silicon dioxide layer (60) such as a doped silicon dioxide layer. The method further includes forming a conductive layer, such as a doped polysilicon layer (64), that is provided within the storage node contact area (62) and on an upper surface of the silicon dioxide layer (60). The method also includes forming a hardened photoresist structure (66) on an upper surface of the doped polysilicon layer (64). The method further includes removing portions of the doped polysilicon layer (64), not residing under the hardened photoresist structure (66), to form the bottom electrode (68).

## Description

### TECHNICAL FIELD OF THE INVENTION

This invention relates generally to the field of semiconductor devices and more particularly to a structure and method for forming a bottom electrod.e of a stacked capacitor of a dynamic random access memory cell.

### BACKGROUND OF THE INVENTION

One of the goals in the design of dynamic random access memory ("DRAM") is to increase the memory capacity of each integrated circuit. To increase the memory capacity, significant efforts have been made at decreasing the size of each of the DRAM cells that make up the DRAM. One of the most challenging problems faced by DRAM designers is the maintenance of sufficient charge-storage capacity in the capacitors of the DRAM cells as their area is decreased, particularly as the area is decreased to sub-micron dimensions.

To maintain sufficient charge-storage capacity in stacked capacitor type DRAMs, as the DRAM cell area decreases with increased integration, improvements must be made generally in at least one of three areas. The first area involves finding a material with a higher dielectric constant for use in the stacked capacitor. Problems have been encountered because, in addition to having a higher dielectric constant, the material must be suitable for use in the semiconductor fabrication process. The second area involves decreasing the thickness of the dielectric material in the stacked capacitor. However, when the dielectric becomes too thin, charge may leak through causing device failure or breakdown. The final area, which is the focus of the present invention, involves increasing the cross-sectional area of the bottom electrode and the upper electrode of the stacked capacitor to effectively increase the storage-node area without increasing the overall DRAM cell area or even decreasing the DRAM cell area. By increasing the cross-sectional area of the bottom electrode and the upper electrode, the charge-storage capacity is increased.

To maintain sufficient charge-storage capacity in stacked capacitor type DRAMs, various techniques have been proposed to increase the cross-sectional area of the electrodes of the stacked capacitor to effectively increase the storage node area beyond the amount allocated within each DRAM cell. One such technique involves forming a crown-shaped stacked capacitor that effectively increases the storage node area.

In forming the bottom electrode of the crown-shaped stacked capacitor, multiple patterns must be formed and multiple polysilicon layer depositions, etch-backs, nitride layer depositions, and oxide layer depositions may be required. Additionally, a deglazing step, using etching techniques to remove oxide layers, may also have to be performed using an HF wet etch. All of these steps and processes significantly increase overall DRAM fabrication complexity, time, cost, and yield. Furthermore, the multiple patterns and etches increase the chances of an overetch. An overetch in the storage node contact area of a DRAM cell may increase contact resistance which reduces DRAM performance.

Another disadvantage of the prior techniques used to fabricate the bottom electrode of a crown-shaped stacked capacitor is that conventional photolithographic techniques and tools cannot be used to directly form sub-lithographic features that comprise crown like structures. Conventional photolithographic techniques and tools are limited to forming features of structures that are no smaller than their wavelengths. For example, conventional photolithographic techniques may include a minimum feature size of 0.3 microns. As the demand for increased DRAM integration continues, the demand for smaller DRAM cells having smaller stacked capacitors is correspondingly increased. Thus, as the demand increases for smaller stacked capacitors having features smaller than the minimum feature size that can be provided directly by conventional photolithography, conventional photolithography can no longer be used to directly fabricate these structures. This significantly increases overall DRAM costs.

### SUMMARY OF THE INVENTION

From the foregoing it may be appreciated that a need has arisen for a structure and method for forming a bottom electrode of a stacked capacitor of a DRAM cell that eliminate or reduce the problems described above. In accordance with the present invention, a structure and method for forming a bottom electrode of a stacked capacitor of a DRAM cell is provided that includes the formation of a bottom electrode using minimal steps, such as a single pattern and etch step.

According to an embodiment of the present invention, a method for forming a bottom electrode of a stacked capacitor of a DRAM cell is provided that includes the following steps. A storage node contact area is formed in an insulator layer of the dynamic random access memory cell. Next, a conductive layer is formed within the storage node contact area and on an upper surface of the insulator layer. A hardened photoresist structure is then formed on an upper surface of the conductive layer. Finally, portions of the conductive layer, not residing under the hardened photoresist structure, are removed to form the bottom electrode.

The present invention provides various technical advantages. A technical advantage of the present invention includes the formation of a bottom electrode of a stacked capacitor, such as a crown-shaped stacked capacitor, with a single pattern and etch step or with minimal pattern and etch steps. The reduction in the number of pattern and etch steps reduces overall DRAM fabrication cost, time, complexity, while increasing overall DRAM yield and reliability. Another technical advantage of the present invention includes the ability to practice the invention using conventional fabrication equipment and tools. Yet another technical advantage of the present invention includes the ability to use conventional photolithographic tools to achieve non-conventional patterns and sub-lithographic dimensions when forming the bottom electrode. The bottom electrode may be fabricated at dimensions below the minimum feature size using conventional photolithographic tools which results in substantial savings over other techniques and allows DRAM integrated circuits to be fabricated in a batch mode. Other technical advantages are readily apparent to one skilled in the art from the following FIGUREs, description, and claims.

### BRIEF DESCRIPTION OF THE DRAWINGS

The present invention will now be further described by way of example, with reference to the accompanying drawings in which:
FIGUREs 1A through 1E are a series of schematic cross-sectional diagrams illustrating one embodiment of a method for forming a hardened photoresist structure according to the teachings of the present invention; and
FIGUREs 2A through 2D are a series of schematic cross-sectional diagrams illustrating one embodiment of a method for forming the bottom electrode of a stacked capacitor of a dynamic random access memory cell according to the teachings of the present invention.

### DETAILED DESCRIPTION OF THE INVENTION

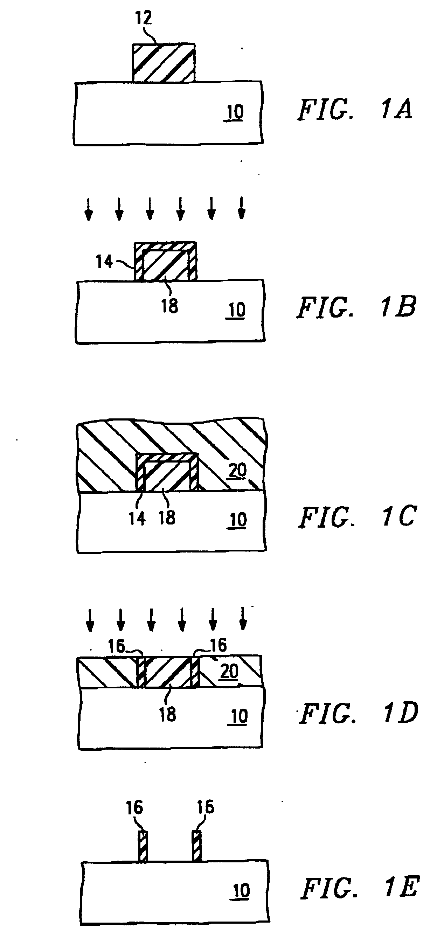

FIGUREs 1A through 1E are a series of schematic cross-sectional diagrams illustrating one embodiment of a method for forming a hardened photoresist structure 16 of the present invention. Referring now to FIGURE 1A, a layer 10 is provided with a resist body 12 positioned on an upper surface of layer 10. Layer 10 may be any layer such as a silicon bulk substrate layer, a polysilicon layer such as an insitu doped polysilicon layer, or any conductive layer such as a metal layer. For example, modern techniques for forming bottom electrode structures that utilize some of the newer dielectric materials such as tantalum pentoxide or barium strontium titanate.

Resist body 12 is fabricated by first coating layer 10 with a layer of photoresist at a prescribed thickness and uniformity. The layer of photoresist is then patterned with a designated reticle. The layer of photoresist is then exposed and developed to transfer the pattern from the reticle or mask to the photoresist layer. The resulting developed photoresist forms a resist body 12 and resides on an upper surface of layer 10. Resist body 12 may be provided in virtually any shape or configuration. For example, resist body 12 is illustrated in FIGURE 1A as a cross-sectional view of a body that is formed as a rectangular body when viewed from the top and when looking down onto the upper surface of layer 10. However, it should be understood that the present invention is not limited to only rectangular bodies but may encompass virtually any shape such as a circular or oval shape when viewed from the top. The photoresist layer may be exposed to provide resist body 12 using any known or conventional exposure tool such as an optical, E-beam, focused ion beam, x-ray or other exposure tools, including patterning enhancement techniques such as phase shift masks, pupil filter, etc., that can linearize the pattern on the photoresist. The photoresist may be provided as a positive photoresist or as a negative photoresist but will preferably be provided as a positive photoresist.

Referring next to FIGURE 1B, photoresist body 12 is then subjected to a resist hardening process to harden an outer portion or outer shell of resist body 12. An outer portion 14 and a remaining portion 18 are shown in FIGURE 1B. Outer portion 14 may be formed to a predetermined or a prescribed thickness.

The hardening of outer portion 14 can be accomplished using a high temperature bake, ultraviolet resist hardening, or other resist hardening methods. The resist hardening process is controlled so that the hardening procedure takes place from the surface of resist body 12 and proceeds inwardly to a desired depth to form outer portion 14 as illustrated in FIGURE 1B. As a consequence, remaining portion 18 is provided within outer portion 14 and is not hardened by the resist hardening process. The resist hardening process is indicated in FIGURE 1B by the downwardly pointing arrows.

Referring next to FIGURE 1C, a coating 20 may be applied to cover outer portion 14 and the remaining upper surface of layer 10. The coating may be either positive or negative resist, or any other material, which can provide the function described below without adversely affecting the procedures or steps used in device fabrication. Coating 20 may also be provided as an inorganic or organometallic compound. In such a case, coating 20 may be applied by spin-on and heat treatment or by chemical vapor deposition. Coating 20 is then removed, using any known or conventional removal process such as chemical-mechanical polishing, dry etch, or the like, until the top of outer portion 14 is removed as shown in FIGURE 1D.

Coating 20 is applied to provide mechanical stability during subsequent etching and processing steps. However, the present invention may be performed without including coating 20. Thus, it should be understood that the present invention does not require the application of coating 20 and subsequent removal.

Referring now to FIGURE 1D, a portion of coating 20 is removed from the upper surface along with the upper surface of outer portion 14 which results in the formation of a hollow structure that may be referred to as hardened photoresist structure 16. Remaining portion 18 is now exposed at an upper surface and may be removed by developing the structure as illustrated in FIGURE 1E. The structure may now be developed using an appropriate solvent or mixture of solvents to remove remaining portion 18, which is the unhardened portion of the resist. The downwardly pointing arrows of FIGURE 1D indicate that the structure is being developed. The remaining portions of coating layer 20 are also removed during this process.

Referring now to FIGURE 1E, hardened photoresist structure 16 remains. Hardened photoresist structure 16 may be provided in virtually shape or configuration. For example, when viewed from the top, hardened photoresist structure 16 may be in the shape of a ring, an oval, a square, a rectangle, or virtually any other desired shape. The distance of the hollowed out portion, or the distance between the two elements of hardened photoresist structure 16, as illustrated in FIGURE 1E, may be provided at sub-lithographic distances.

FIGUREs 2A through 2D are a series of schematic cross-sectional diagrams illustrating one embodiment of a method for forming a bottom electrode 68 of a stacked capacitor as fabricated in a dynamic random access memory ("DRAM") cell. Referring now to FIGURE 2A, a partially formed DRAM cell is provided that includes a storage node contact area 62 for forming a crown-shaped stacked capacitor. Storage node contact area 62 couples to a drain region 54 that is provided as part of a field-effect transistor ("FET") that forms the DRAM cell in combination with the stacked capacitor. Thus, the DRAM cell may generally be divided into a transistor or FET portion and a stacked capacitor portion for providing charge-storage capacity. It should also be noted that for simplicity and illustrative reasons, a bit line contact and a bit line, which would normally be included as part of a DRAM cell, are not shown in FIGUREs 2A through 2D.

The FET portion of the partially formed DRAM cell includes drain region 54 and a source region 52 formed within a substrate 50. Substrate 50 may be provided as a bulk silicon substrate or as a doped silicon substrate. The FET portion also includes a gate oxide 56, a gate 58, and an insulator layer. The insulator layer may be implemented using silicon dioxide and is shown in FIGURE 2A as a silicon dioxide layer 60. Silicon dioxide layer 60 may be formed using any known or conventional deposition technique. Silicon dioxide layer 60 will preferably be formed through deposition and will include a dopant such as boron, phosphorous or both. Storage node contact area 62 may be formed using any known or conventional etching technique. Storage node contact area 62 may be formed using an anisotropic etch such as by performing a dry etch.

The FET portion of the partially formed DRAM cell may be formed using any known or conventional fabrication techniques for forming an FET. For example, source region 52 and drain region 54 may be formed by performing ion implantation to implant impurities or dopants into these regions. Source region 52 and drain region 54 will generally be provided as n-type regions but could be provided as p-type regions. Gate oxide 56 serves as an insulator between the channel of the FET and the gate 58. Gate 58 can generally be formed by depositing polysilicon and a refractory metal, such as titanium or tungsten, on the surface of gate oxide 56. Of course, gate 58 may be implemented using any conductor such as a metal.

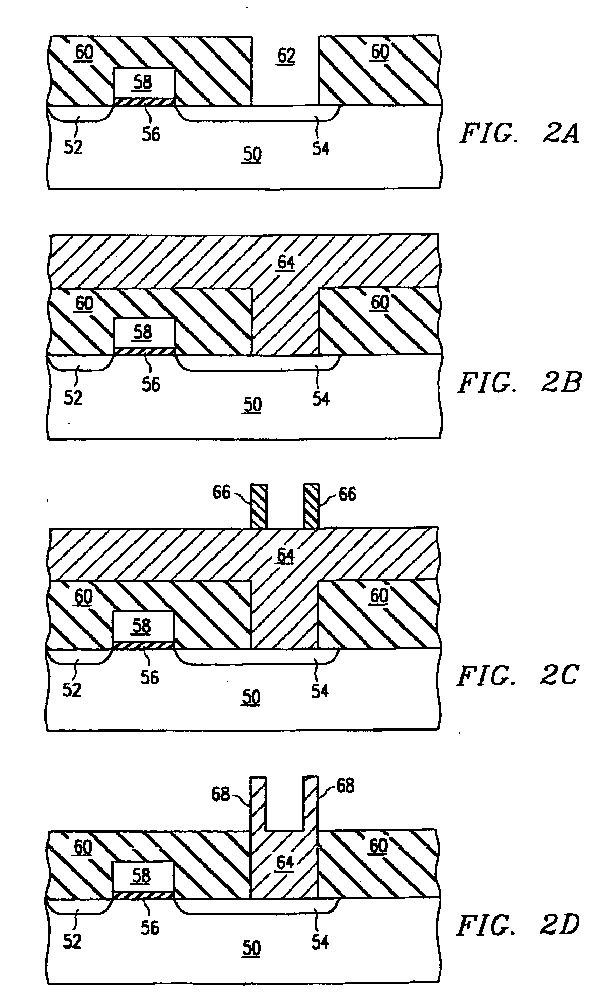

Referring next to FIGURE 2B, a doped polysilicon layer 64 is formed on the surface of silicon dioxide layer 60 and within storage node contact area 62. Doped polysilicon layer 64 may be doped using any known or conventional method. Preferably, doped polysilicon layer 64 will be provided as an insitu doped polysilicon layer. In such a case, doped polysilicon layer 64 may be formed by depositing polysilicon by heating silane to a certain temperature, normally above 6200C, and adding a dopant, such as phosphene, at a desired flow rate to create a doped polysilicon layer. This allows doped polysilicon layer 64 to be formed in one step. Although doped polysilicon layer 64 has been described as an insitu doped polysilicon layer, it should be understood that the present invention encompasses any method of forming doped polysilicon layer 64 and may include any known or conventional technique, such as ion implantation, for forming a doped polysilicon layer. In fact, the present invention encompasses any conductive layer that may be positioned where doped polysilicon layer 64 is shown in FIGURE 2B. Also, doped polysilicon layer 64 may be doped using either p-type dopants or n-type dopants.

Referring now to FIGURE 2C, hardened photoresist structure 66 is formed on the upper surface of doped polysilicon layer 64. Hardened photoresist structure 66 is also positioned over storage node contact area 62 and is formed using the process and techniques described previously and illustrated FIGURES 1A through 1E. Hardened photoresist structure 66 may be formed in the same manner in which hardened photoresist structure 16 of FIGUREs 1A through 1E was formed. Thus, hardened photoresist structure 66 may be provided at dimensions that are sub-lithographic.

FIGURE 2C illustrates a cross-sectional view of hardened photoresist structure 66. Thus, the shape of hardened photoresist structure 66, when viewed in a top view, may be provided in virtually any shape that provides an inner surface and an outer surface. For example, the top view of hardened photoresist structure 66 may reveal a structure having an oval shape, an elliptical shape, a rectangular shape, a square shape, or virtually any shape that includes an inner surface and an outer surface. The inner surface is defined as the surfaces provided on hardened photoresist structure 66 that reside between the two cross-sectional structures of hardened photoresist structure 66 as shown in FIGURE 2C. The outer surfaces of hardened photoresist structure 66 may be defined as the remaining surfaces. Preferably, the top view of hardened photoresist structure 66 will be provided in an oval shape, however, the present invention encompasses other shapes as well. For example, a resist body, similar to resist body 12 of FIGURE 1A, may initially be provided as a rectangular, three-dimensional body. As a result of performing the steps illustrated in FIGURE 1A through 1E, the corners of the rectangular resist body are rounded which results in the formation of the oval shape of hardened of photoresist structure 66.

Referring finally to FIGURE 2D a bottom electrode 68 is fabricated using hardened photoresist structure 66. Harden photoresist structure 66 serves as a masking or blocking layer while performing a substantially anisotropic etch of doped polysilicon layer 64. An anisotropic etch is, by definition, an etch that is not isotropic. An isotropic etch is defined as an etch that precedes in all directions at the same rate. After the anisotropic etch, any remaining portions of hardened photoresist structure 66 are removed and the structure as illustrated in FIGURE 2D is provided.

As a consequence of the anisotropic etch, a portion of doped polysilicon layer 64 still resides within storage node contact area 62 and below where the hardened photoresist structure 66 previously resided to form bottom electrode 68. The portion of doped polysilicon layer 64 that still resides within storage node contact area 62 serves as an electrical path between bottom electrode 68 and drain region 54. Bottom electrode 68 serves as the bottom or lower electrode of a crown-shaped stacked capacitor.

Just as with hardened photoresist structure 66, bottom electrode 68 may be provided in any of a variety of configurations, for example, the top view of bottom electrode 68 may reveal a square shape, a rectangular shape, an oval shape, a circular shape, an elliptical shape, or any of a variety of other shapes. The top view of bottom electrode 68 will preferably reveal an oval shape. The charge-storage area of bottom electrode 68 will include the area of the outside surfaces plus the area of the inside surfaces.

The remaining portions of the crown-shaped stacked capacitor may be formed by forming a dielectric layer on the exposed surfaces of bottom electrode 68. An upper electrode may then be formed on the dielectric layer to complete the formation of the crown-shaped stacked capacitor. The upper electrode may be formed conformally and fabricated from any of a variety of materials such as polysilicone. The formation of bottom electrode 68 provides a significantly increased surface area that may double the capacitor area as compared to other stacked capacitors, such as block-shaped stacked capacitors of the same height. Referring again to FIGURE 2D, if the remaining portions of the crown-shaped stacked capacitor are formed, the lines denoting the exposed surfaces of bottom electrode 68 may represent the dielectric layer and the upper electrode of an entire crown-shaped stacked capacitor.

In an alternative embodiment, a thin layer of oxide may be formed on the upper surface of doped polysilicon layer 64 before hardened photoresist structure 66 is fabricated as shown in FIGURE 2C. Hardened photoresist structure 66 is then fabricated on an upper surface of the thin layer of oxide. The thin layer of oxide may be provided as any insulator layer material. The thin layer of oxide provides additional stability to hardened photoresist structure 66 during the etching process and increases the anistropic of the subsequent etch of doped polysilicon layer 64. The thin layer of oxide is then removed everywhere, except for the remaining portions residing below or underneath hardened photoresist structure 66, using an anistropic oxide etching step. The oxide etch is performed such that only the thin oxide layer is removed without removing portions of the doped polysilicon layer 64. As mentioned, the remaining portions of the thin oxide layer serves to provide added stability to hardened photoresist structure 66 during the ensuing anistropic etch of doped polysilicon layer 64.

Hardened photoresist structure 66 is produced using known or conventional photolithography, and is generated at sub-lithographic dimensions which are provided below the minimum feature size or critical dimension.

Thus, it is apparent there has been provided, in accordance with the present invention, a structure and method for forming a bottom electrode of a stacked capacitor of a dynamic random access memory cell that satisfies the advantages set forth above. The present invention provides a method for creating a crown-shaped stacked capacitor using minimal steps and using conventional photolithographic techniques and tools. As a result, the present invention provides significant fabrication advantages and reduces overall DRAM fabrication cost, time, complexity, while increasing overall DRAM fabrication yield and reliability. Although the preferred embodiment has been described in detail, it should be understood that various changes, substitutions, and alterations can be made herein without departing from the scope of the present invention. For example, as mentioned previously, the coating 20 may or may not be required to practice the present invention. Similarly, the thin oxide layer may be provided before hardened photoresist structure 66 is fabricated as described above. Other examples of changes, substitutions, and alterations are readily ascertainable by one skilled in the art and could be made without departing from the spirit and scope of the present invention.

## Claims

1. A method for forming a bottom electrode of a stacked capacitor of a dynamic random access memory cell, which method comprising the steps of:
forming a storage node contact region in an insulator layer of the dynamic random access memory cell;
forming a conductive layer substantially within the storage node contact region and over an upper surface of the insulator layer;
forming a hardened photoresist structure over an upper surface of the conductive layer; and
removing portions of the conductive layer not disposed under the hardened photoresist structure to form the bottom electrode.

2. The method of Claim 1, wherein the step of forming the conductive layer comprises forming a doped polysilicon layer.

3. The method of Claim 1, wherein the step of forming the conductive layer comprises forming an insitu doped polysilicon layer.

4. The method of any preceding claim, wherein the step of forming a hardened photoresist structure comprises:
forming a photoresist layer over the upper surface of the conductive layer ;
patterning the photoresist layer to form a photoresist body positioned substantially over the storage node contact region on the upper surface of the conductive layer;
hardening a predetermined outer portion of the photoresist body to provide a hardened outer layer of the photoresist body, remaining portions of the photoresist body having essentially unaltered properties; and
removing a portion of the hardened outer layer and remaining portions of the photoresist body having essentially unaltered properties to form the hardened photoresist structure of a desired shape.

5. The method of Claim 4, wherein the step of forming a hardened photoresist structure comprises forming the hardened photoresist structure in a shape that will form the bottom electrode in a desired shape as a result of performing the step of removing portions of the conductive layer.

6. The method of any preceding Claim, wherein the step of removing portions of the conductive layer comprises includes removing portions of the conductive layer provided substantially over the upper surface of the insulator layer.

7. The method of Claim 6, wherein the step of removing portions of the conductive layer comprises performing an anisotropic etch.

8. The method of any preceding Claim, wherein the step of removing portions of the conductive layer removing a portion of the conductive layer disposed substantially under the hardened photoresist structure.

9. The method of any preceding Claim, wherein the step of forming the bottom electrode comprises forming a crown-shaped bottom electrode.

10. The method of any preceding Claim, wherein the step of forming the hardened photoresist structure comprises forming a hardened photoresist structure substantially in a crown-shaped configuration to ensure that the bottom electrode is formed as a crown-shaped bottom electrode.

11. The method of any preceding Claim, wherein the step of forming the insulator layer comprises forming a doped silicon dioxide layer.

12. The method of any preceding Claim, further comprising the steps of:
forming a second insulator layer over the upper surface of the conductive layer before the forming a hardened photoresist structure and wherein the step of forming a hardened photoresist structure comprises forming the hardened photoresist structure over an upper surface of the second insulator layer; and
removing the second insulator layer after the step of forming a hardened photoresist structure so that a portion of the second insulator layer remains below the hardened photoresist structure.

13. The method of Claim 12, wherein the steps of forming the conductive layer and the second insulator layer comprise forming a conductive layer comprising a doped polysilicon layer and a second insulator layer that is a relatively thin silicon dioxide layer.

14. A method for forming a dynamic random access memory cell, the method comprising the steps of:
forming a partial dynamic random access memory cell that includes a control region, first and second guiding regions, and an insulator layer disposed substantially over the current guiding regions;
forming a storage node contact area in the insulator layer of the dynamic random access memory cell to expose a portion of the first current guiding region;
forming a conductive layer within the storage node contact area and over an upper surface of the insulator layer;
forming a hardened photoresist structure over an upper surface of the conductive layer;
removing portions of the conductive layer not residing under the hardened photoresist structure to form the bottom electrode;
forming a dielectric layer over exposed surfaces of the bottom electrode; and
forming an upper electrode over exposed surfaces of the dielectric layer.

15. The method of Claim 14, wherein the steps of forming bottom electrode, the dielectric layer, and the upper electrode comprise forming a stacked capacitor.

16. The method of Claim 15, wherein the step of forming the control region, and first and second current guiding regions comprises forming a field-effect transistor that is operable to couple with the stacked capacitor to form a dynamic random access memory cell.

17. The method of any of Claims 14 to 16, wherein the step of forming a dielectric layer and an upper electrode comprise a conventional deposition technique.

18. A structure for forming a bottom electrode of a stacked capacitor of a dynamic random access memory cell, the structure comprising:
a partial dynamic random access memory cell that includes a control region, first and second current guiding regions, and an insulator layer disposed substantially over the first and the second current guiding regions, the partially dynamic random access memory cell further comprising a storage node contact area in the insulator layer disposed substantially over a portion of the first current guiding region;
a conductive layer positioned within the storage node contact area and on an upper surface of the insulator layer; and
a hardened photoresist structure formed over an upper surface of the conductive layer.

19. The structure of Claim 18, wherein the conductive layer is a doped polysilicon layer.

20. The structure of Claim 18 or Claim 19, wherein the hardened photoresist structure is provided in a shape that will form the bottom electrode in a desired shape as a result of removing portions of the conductive layer by performing an anisotropic etch.
